# EUROPÄISCHE PATENTANMELDUNG

(11) **EP 4 057 485 A2**
(43) Veröffentlichungstag der Anmeldung: **14.09.2022**
(21) Anmeldenummer: 22159612.5
(22) Anmeldetag: 02.03.2022
(51) Int. Cl.: H02K 11/33, H05K 7/20

(54) **ELEKTRISCHE ANTRIEBSVORRICHTUNG FÜR EIN FAHRZEUG UND ELEKTRONIKBAUGRUPPE FÜR EINE ELEKTRISCHE ANTRIEBSVORRICHTUNG**

(30) Priorität: 12.03.2021 DE 102021202450
(71) Anmelder: Robert Bosch GmbH, 70442 Stuttgart (DE)
(72) Erfinder: Kuhnle, Daniel, 71665 Vaihingen/Enz (DE); Burger, Dennis, 71292 Friolzheim (DE)

(57) **Zusammenfassung**

Eine Elektronikbaugruppe für eine elektrische Antriebsvorrichtung umfasst ein Gehäuse, welches einen Innenraum definiert und zumindest teilweise aus einem elektrisch leitfähigen Material gebildet ist, und eine plattenförmige Kühleinrichtung, welche in dem Innenraum des Gehäuses angeordnet ist und in dem Innenraum eine erste Zone und eine zweite Zone voneinander trennt, wobei die plattenförmige Kühleinrichtung eine Oberfläche aus elektrisch leitfähigem Material aufweist, welche in elektrischem Kontakt mit einem elektrisch leitfähigen Bereich des Gehäuses angeordnet ist. Ferner umfasst die Elektronikbaugruppe ein in der ersten Zone des Innenraums angeordnete leistungselektronische Schaltung zur elektrischen Verbindung mit einer elektrischen Maschine und eine in der zweiten Zone des Innenraums angeordnete signalelektronische Schaltung, welche elektrisch mit der leistungselektronischen Schaltung verbunden und dazu eingerichtet ist, diese zu steuern.

## Beschreibung

### Technisches Gebiet

Die vorliegende Erfindung betrifft eine Elektronikbaugruppe für eine elektrische Antriebsvorrichtung eines Fahrzeugs sowie eine elektrische Antriebsvorrichtung für ein Fahrzeug.

### Stand der Technik

Ganz oder teilweise elektrisch angetriebene Fahrzeuge weisen eine Antriebsvorrichtung mit einem Elektromotor auf, welcher kinematisch an zumindest eine Achse oder an zumindest ein Rad des Fahrzeugs gekoppelt ist, um diese bzw. dieses anzutreiben. Typischerweise ist als elektrische Energiequelle für den Motor ein elektrischer Energiespeicher, z.B. ein Akkumulator, vorgesehen und der Elektromotor ist über eine Leistungselektronik mit dem Energiespeicher elektrisch verbunden. Die Leistungselektronik leitet dabei hohe elektrische Ströme und enthält außerdem relativ temperaturempfindliche elektronische Komponenten, wie z.B. Logikschaltungen, Mikroprozessoren oder dergleichen, welche in einem Gehäuse untergebracht sind. Um eine Überhitzung der Leistungselektronik zu vermeiden, ist typischerweise eine Kühleinrichtung vorgesehen. Aufgrund der hohen elektrischen Ströme werden üblicherweise auch Maßnahmen zur elektromagnetischen Abschirmung getroffen.

Die DE 10 2010 042 182 A1 beschreibt ein leistungselektronisches Modul für ein Fahrzeug mit mehreren in einem Gehäuse angeordneten elektronischen Schaltelementen, wobei an einer Rückwand des Gehäuses eine Kühleinrichtung angebracht ist. Eine Platine mit einer bügelförmigen Kühleinrichtung, welche mit der Platine verbunden ist, wird in der WO 2018/141641 A1 offenbart.

In der EP 3 524 463 A1 wird eine Elektronikeinheit für induktive Ladesysteme offenbart, wobei in einem Gehäuse leistungselektronische Platinen an entgegengesetzten Oberflächen einer Kühlplatte angeordnet sind.

In der DE 10 2015 200 866 A1 wird ferner eine elektrische Antriebsvorrichtung beschrieben, welche einen Elektromotor und eine Ansteuerelektronik aufweist. Der Elektromotor ist in einem Gehäuse aufgenommen, welches stirnseitig durch einen einen Kühlkörper bildenden Alugusskörper verschlossen ist. An einer dem Elektromotor abgewandten Seite des Alugusskörpers ist eine Platine der Ansteuerelektronik befestigt und durch ein Umspritzmaterial eingeschlossen. Der Kühlkörper bildet eine elektromagnetische Abschirmung.

### Offenbarung der Erfindung

Erfindungsgemäß sind eine Elektronikbaugruppe mit den Merkmalen des Anspruchs 1 sowie eine elektrische Antriebsvorrichtung mit den Merkmalen des Anspruchs 10 vorgesehen.

Gemäß einem ersten Aspekt der Erfindung umfasst eine Elektronikbaugruppe für eine elektrische Antriebsvorrichtung ein Gehäuse, welches einen Innenraum definiert und zumindest teilweise aus einem elektrisch leitfähigen Material gebildet ist und eine plattenförmige Kühleinrichtung, welche in dem Innenraum des Gehäuses angeordnet ist und in dem Innenraum eine erste Zone und eine zweite Zone voneinander trennt, wobei die plattenförmige Kühleinrichtung eine Oberfläche aus elektrisch leitfähigem Material aufweist, welche in elektrischem Kontakt mit einem elektrisch leitfähigen Bereich des Gehäuses angeordnet ist. Ferner weist die Elektronikbaugruppe eine in der ersten Zone des Innenraums angeordnete leistungselektronischen Schaltung zur elektrischen Verbindung mit einer elektrischen Maschine und eine in der zweiten Zone des Innenraums angeordnete signalelektronische Schaltung auf, welche elektrisch mit der leistungselektronischen Schaltung verbunden und dazu eingerichtet ist, diese zu steuern.

Gemäß einem zweiten Aspekt der Erfindung umfasst eine elektrische Antriebsvorrichtung für ein Fahrzeug eine Elektronikbaugruppe nach dem ersten Aspekt der Erfindung und eine elektrische Maschine, welche elektrisch mit der leistungselektronischen Schaltung der Elektronikbaugruppe verbunden ist.

Eine der Erfindung zugrundeliegende Idee besteht darin, in einem Gehäuse einer Elektronikbaugruppe, eine plattenförmige Kühleinrichtung derart anzuordnen, dass die Kühleinrichtung gemeinsam mit elektrisch leitfähigen Strukturen des Gehäuses, wie z.B. Wandungen, welche den Innenraum des Gehäuses umgrenzen, einen Faraday'schen Käfig ausbildet, in welchem eine leistungselektronische Schaltung, wie z.B. eine Inverterschaltung, aufgenommen ist. Insbesondere teilt die Kühleinrichtung den Innenraum des Gehäuses in eine erste Zone auf, welche einen Faraday'schen Käfig bildet, und eine von dieser getrennten zweiten Zone, in welcher eine signalelektronische Schaltung angeordnet ist. Allgemein bilden ist die Kühleinrichtung derart im Innenraum des Gehäuses angeordnet und mit dem Gehäuse elektrisch kontaktiert, dass die Kühleinrichtung und das Gehäuse gemeinsam einen Faraday'schen Käfig in einem Teilbereich des Innenraums definieren. Die Kühleinrichtung ist plattenförmig und weist eine Oberfläche aus elektrisch leitfähigem Material auf, welche zumindest punktweise oder flächig in leitfähigem Kontakt mit leitfähigen Strukturen des Gehäuses steht. Die leistungselektronische Schaltung und die signalelektronische Schaltung sind durch eine Verkabelung elektrisch zur Signalleitung verbunden, wobei die Verkabelung beispielsweise durch eine die erste und die zweite Zone verbindende Ausnehmung der Kühleinrichtung geführt sein kann. Die signalelektronische Schaltung kann insbesondere Sicherungen und eine Prozessoreinrichtung, wie z.B. eine CPU, einen FPGA, einen ASIC oder dergleichen enthalten, welche dazu eingerichtet ist, Schaltungselemente der leistungselektronischen Schaltung anzusteuern. Optional kann vorgesehen sein, dass die signalelektronische Schaltung und/oder die leistungselektronische Schaltung in Kontakt mit der Kühleinrichtung ist.

Ein Vorteil der Erfindung ist es, dass durch die Kühleinrichtung eine elektromagnetische Abschirmung der leistungselektronischen Schaltung, insbesondere relativ zu der signalelektronischen Schaltung erzielt wird. Somit wird mit einer geringen Anzahl an Komponenten eine Abschirmung realisiert und eine einfach aufgebaute Elektronikbaugruppe mit hohem Integrationsgrad bereitgestellt.

Vorteilhafte Ausgestaltungen und Weiterbildungen ergeben sich aus den weiteren Unteransprüchen sowie aus der Beschreibung unter Bezugnahme auf die Figuren der Zeichnungen.

Gemäß manchen Ausführungsformen kann vorgesehen sein, dass die Kühleinrichtung entlang ihres Umfangs an einer Vielzahl von Verbindungsstellen, die vorzugsweise äquidistant zueinander angeordnet sind, elektrisch leitfähig mit dem Gehäuse verbunden ist. Beispielsweise kann die Kühleinrichtung an den Verbindungsstellen mit dem Gehäuse verschraubt, verschweißt, verrastet oder in ähnlicher Weise an dem Gehäuse in leitfähiger Weise befestigt sein. Durch die Verbindung an einer Vielzahl von Stellen wird die Montage der Kühleinrichtung erleichtert und die elektromagnetische Abschirmung weiter verbessert.

Gemäß manchen Ausführungsformen kann vorgesehen sein, dass die erste Zone durch einen Boden des Gehäuses, vom Boden des Gehäuses vorstehende Wandungen und durch die Kühleinrichtung begrenzt ist. Die Wandungen und der Boden des Gehäuses können z.B. einstückig ausgebildet sein, insbesondere aus einem Metallmaterial, wie z.B. einer Aluminiumlegierung. Allgemein weisen Boden und Wandungen zumindest eine elektrisch leitfähige Oberfläche auf. Die Kühleinrichtung ist somit gegenüberliegend zu dem Boden angeordnet und erstreckt sich vorzugsweise parallel zu diesem.

Gemäß manchen Ausführungsformen kann vorgesehen sein, dass die erste Zone durch den Boden des Gehäuses, durch zumindest in einem Randbereich des Bodens angeordnete Seitenwandung, durch eine mit der Seitenwandung verbundene Trennwand und durch die Kühleinrichtung begrenzt ist. Beispielsweise kann die erste Zone durch zwei gegenüberliegende Seitenwandungen und eine diese verbindende Seitenwandung und eine sich zwischen den gegenüberliegenden Seitenwandungen erstreckende Trennwand sowie die Kühleinrichtung begrenzt sein. Durch die Anbringung der Kühleinrichtung an der Trennwand, z.B. an einem vom Boden abgewandten Ende der Trennwand, und an der Seitenwand, z.B. an einem von diesem vorspringenden Absatz, wird auf konstruktiv einfache Weise die erste Zone umgrenzt.

Gemäß manchen Ausführungsformen kann vorgesehen sein, dass die Trennwand in dem Innenraum des Gehäuses eine dritte Zone von der ersten Zone trennt, und wobei in der dritten Zone eine Filterschaltung angeordnet ist, welche elektrisch in Reihe mit der leistungselektronischen Schaltung geschalten ist. Die Filterschaltung kann beispielsweise dazu eingerichtet sein, Rippelströme bzw. -spannungen in einem vorbestimmten ersten Frequenzbereich zu filtern. Die Trennwand bietet somit den weiteren Vorteil, dass der Boden des Gehäuses als Begrenzung für zwei verschiedene Zonen genutzt werden kann, wodurch sich ein noch kompakterer Aufbau erzielen lässt.

Gemäß manchen Ausführungsformen kann vorgesehen sein, dass die zweite Zone durch die Kühleinrichtung, zumindest teilweise durch die Wandungen und durch einen Deckel des Gehäuses begrenzt ist. Der Deckel des Gehäuses kann insbesondere lösbar mit den Seitenwandungen verbunden sein, z.B. mit diesen verschraubt. Ferner kann vorgesehen sein, dass Deckel und Seitenwände elektrisch miteinander kontaktiert sind. Die erste und die zweite Zone sind somit in Bezug auf eine Richtung quer zum Boden übereinander angeordnet, insbesondere auf entgegengesetzten Seiten der Kühleinrichtung. Somit wird ein sehr kompakter Aufbau realisiert.

Gemäß manchen Ausführungsformen kann vorgesehen sein, dass die zweite Zone durch die Kühleinrichtung, durch zumindest eine mit dem Boden verbundene Seitenwandung des Gehäuses, durch eine sich quer zu der Seitenwandung erstreckende Abdeckplatte des Deckels und durch eine von dem Deckel in Richtung der Kühleinrichtung vorspringende Trennleiste begrenzt ist. Optional trennt die Trennleiste die zweite Zone von der dritten Zone. Alternativ ist denkbar, dass der Deckel an einem vom Boden abgewandten Ende der Trennwand anliegt und die dritte Zone somit durch den Boden, die Trennwand und zumindest eine Seitenwand begrenzt ist. In diesem Fall kann die Trennleiste des Deckels weggelassen werden.

Gemäß manchen Ausführungsformen kann vorgesehen sein, dass die leistungselektronische Schaltung eine Umrichterschaltung, die dazu eingerichtet ist, eine elektrische Gleichspannung in eine elektrische Wechselspannung umzurichten und eine elektrische Wechselspannung in eine elektrische Gleichspannung umzurichten, und einen Zwischenkreiskondensator aufweist, welcher elektrisch in Reihe mit der Umrichterschaltung geschalten ist. Optional kann der Zwischenkondensator ferner in Reihe mit einer Filterschaltung geschaltet sein, welche z.B. wie oben beschrieben, in einer weiteren Zone des Innenraums angeordnet sein kann. Der Zwischenkondensator ist dazu eingerichtet, Spannungsrippel bzw. Rippelströme in einem vorbestimmten zweiten Frequenzbereich zu filtern, der von dem ersten Frequenzbereich, der durch die Filterschaltung gefiltert wird, verschieden ist.

Gemäß manchen Ausführungsformen kann vorgesehen sein, dass die Kühleinrichtung eine Kühlplatte aus einem elektrisch leitfähigen Material aufweist, wobei im Querschnitt der Kühlplatte eine Leitungsstruktur zum Durchleiten eines Kühlfluids ausgebildet ist. Beispielsweise kann die Kühlplatte aus Kupfer, Aluminium oder dergleichen gebildet sein. Eine erste Oberfläche der Kühlplatte ist der ersten Zone und eine entgegengesetzt zu der ersten Oberfläche orientierte zweite Oberfläche der Kühlplatte ist der zweiten Zone zugewandt. Eine Dicke der Kühlplatte ist durch einen Abstand der ersten und der zweiten Oberfläche definiert. Der Bereich zwischen der ersten und der zweiten Oberfläche bildet den Querschnitt der Kühlplatte, welcher einen Hohlraum enthält. Der Hohlraum kann z.B. Kanäle oder allgemein einen Strömungsraum definieren, in welchem ein Fluid, z.B. Wasser strömen kann. Beispielsweise kann die Kühlplatte aus zwei Teilplatten zusammengesetzt sein.

Im Folgenden wird die Erfindung unter Bezugnahme auf die Figuren der Zeichnungen erläutert. Von den Figuren zeigen:
- Fig. 1: ein schematisches Blockschaltbild eines Fahrzeugs, welches eine elektrische Antriebsvorrichtung gemäß einem Ausführungsbeispiel der Erfindung aufweist;
- Fig. 2: ein schematisches Blockschaltbild einer elektrischen Antriebsvorrichtung gemäß einem Ausführungsbeispiel der Erfindung;
- Fig. 3: eine schematische Schnittansicht einer Elektronikbaugruppe gemäß einem Ausführungsbeispiel der Erfindung;
- Fig. 4: eine schematische Schnittansicht der in Fig. 3 gezeigten Elektronikbaugruppe, die sich bei einem Schnitt entlang der in Fig. 3 eingezeichneten Linie A-A ergibt; und
- Fig. 5: eine schematische Schnittansicht der in Fig. 3 gezeigten Elektronikbaugruppe, die sich bei einem Schnitt entlang der in Fig. 3 eingezeichneten Linie B-B ergibt.

In den Figuren bezeichnen dieselben Bezugszeichen gleiche oder funktionsgleiche Komponenten, soweit nichts Gegenteiliges angegeben ist.

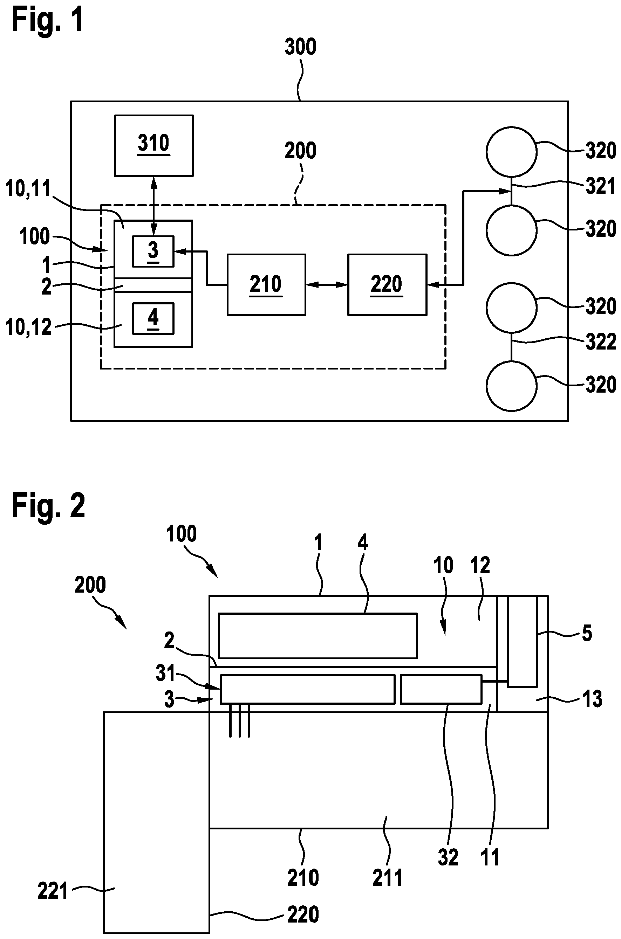

Fig. 1 zeigt rein beispielhaft und schematisch ein Blockschaltbild eines Fahrzeugs 300, insbesondere eines Straßenfahrzeugs, wie ein PKW. Wie in Fig. 1 gezeigt, umfasst das Fahrzeug 300 eine elektrische Energiespeichervorrichtung 310, z.B. in Form eines Akkumulators, eine elektrische Antriebsvorrichtung 200, und zwei Achse 321, 322, wobei je Achse 321, 322 zumindest ein Rad 320 vorgesehen ist. In dem in Fig. 1 beispielhaft gezeigten Fahrzeug 300 sind je Achse 321, 322 zwei Räder 320 vorgesehen.

Wie in Fig. 1 beispielhaft gezeigt, weist die elektrische Antriebsvorrichtung 200 weist eine Elektronikbaugruppe 100, eine elektrische Maschine 210 und ein optionales Getriebe 220 auf.

Die Elektronikbaugruppe 100 wird nachfolgend noch im Detail anhand der Fig. 2 bis 5 erläutert. Allgemein umfasst die Elektronikbaugruppe 100 ein Gehäuse 1, eine Kühleinrichtung 2, eine leistungselektronische Schaltung 3 sowie eine signalelektronische Schaltung 4 zum Steuern der leistungselektronischen Schaltung 3. Wie in Fig. 1 schematisch dargestellt, definiert das Gehäuse 1 einen Innenraum 10, in welchem die Kühleinrichtung 2, die leistungselektronische Schaltung 3 sowie die signalelektronische Schaltung 4 aufgenommen sind.

Wie in Fig. 1 schematisch gezeigt, ist die leistungselektronische Schaltung 3 elektrisch mit der Energiespeichervorrichtung 310 und der elektrischen Maschine 210 verbunden. Die elektrische Maschine 210 kann z.B. eine Drehstrommaschine sein, welche sowohl als Generator als auch als Motor betreibbar ist. Wenn die elektrische Maschine 210 als Motor betrieben wird, nimmt sie elektrische Leistung aus der Energiespeichervorrichtung 310 auf, wobei eine von der Energiespeichervorrichtung 310 gelieferte elektrische Spannung durch die leistungselektronische Schaltung 3 verarbeitet, z.B. von einer Gleichspannung in eine Wechselspannung umgerichtet wird. Wenn die elektrische Maschine 210 als Generator betrieben wird, speist sie elektrische Leistung in die Energiespeichervorrichtung 310 ein, wobei eine von der elektrischen Maschine 210 gelieferte elektrische Spannung durch die leistungselektronische Schaltung 3 verarbeitet, z.B. von einer Wechselspannung in eine Gleichspannung umgerichtet wird.

Die elektrische Maschine 210, ist kinematisch an zumindest einem Rad 320 des Fahrzeugs 300 gekoppelt. Beispielsweise kann eine Rotorwelle (nicht gezeigt) der elektrischen Maschine 210 an einen Eingang des optionalen Getriebes 220 gekoppelt sein, wobei ein Ausgang des Getriebes 220 an zumindest eine der Achsen 321, 322 des Fahrzeugs 300 gekoppelt ist. In Fig. 1 ist rein beispielhaft gezeigt, dass ein Ausgang des Getriebes 220 an nur eine der Achsen 321, 322, nämlich an die Achse 321 gekoppelt ist. Zum Antreiben bzw. Beschleunigen des Fahrzeugs 300 wird die elektrische Maschine 210 als Motor betrieben. Zum Bremsen des Fahrzeugs 300 kann die elektrische Maschine 210 als Generator betrieben werden, wobei die kinetische Energie des Fahrzeugs 300 durch die elektrische Maschine 210 in elektrische Energie umgewandelt und in die Energiespeichervorrichtung 310 eingespeist werden kann.

In Fig. 2 zeigt eine schematische Blockdarstellung der Antriebsvorrichtung 100, in welcher verschiedene voneinander elektromagnetisch abgeschirmte Zonen gezeigt sind. Wie bereits erläutert, sind die Kühleinrichtung 2, die leistungselektronische Schaltung 3 und die signalelektronische Schaltung 4 im Innenraum 10 des Gehäuses 1 angeordnet. Wie in Fig. 2 gezeigt, sind die leistungselektronische Schaltung 3 in einer ersten Zone 11 im Innenraum 10 angeordnet und die signalelektronische Schaltung 4 ist in einer zweiten Zone 12 im Innenraum 10 angeordnet, welche gegenüber der ersten Zone 11 abgeschirmt ist, insbesondere durch die Kühleinrichtung 2. Wie in Fig. 2 ferner dargestellt, kann optional eine dritte Zone 13 im Innenraum 10 des Gehäuses 1 vorgesehen sein, welche gegenüber der ersten Zone 11 und optional auch gegenüber der zweiten Zone 12 abgeschirmt ist, wobei in der dritten Zone 13 eine Filterschaltung 5 angeordnet ist.

Wie in Fig. 2 weiterhin schematisch dargestellt, ist die elektrische Maschine 210 in einer eigenen Motor-Abschirmungszone 211 angeordnet, welche gegenüber den Zonen 11, 12, 13 des Gehäuses 1 abgeschirmt ist, z.B. durch den Stator der elektrischen Maschine 210. Das optionale Getriebe 220 kann ebenfalls in einer eigenen Getriebe-Abschirmungszone 221 angeordnet sein, welche gegenüber der Motor-Abschirmungszone 211 abgeschirmt ist, z.B. durch ein eigenes Gehäuse, um mögliche elektrische Komponenten des Getriebes 220 abzuschirmen, wie z.B. eine elektrische Parksperre oder eine elektrisch betätigbare Kupplung.

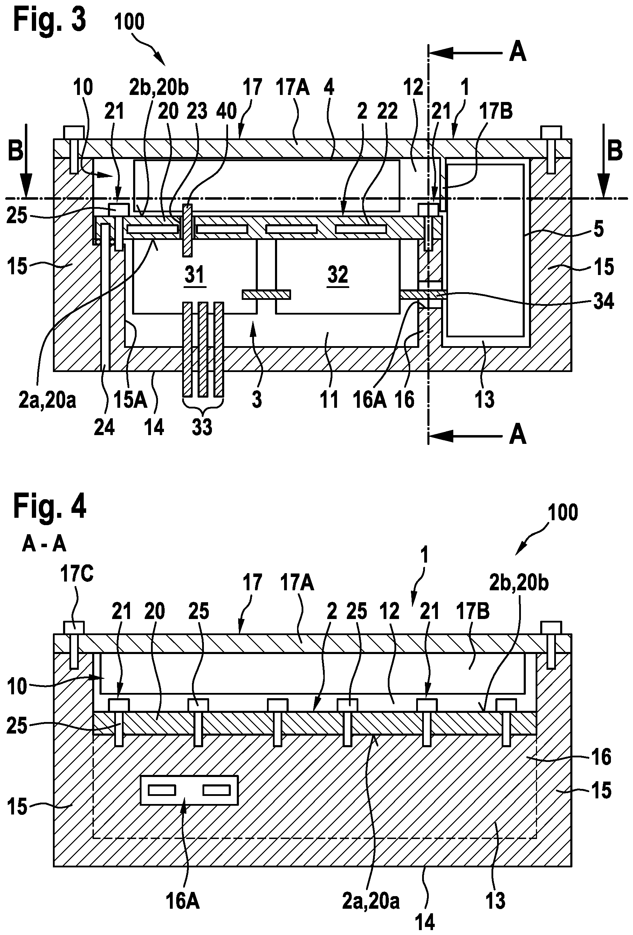

In den Fig. 3 bis 5 ist rein beispielhaft eine Elektronikbaugruppe 100 dargestellt. Wie in den Fig. 3 bis 5 schematisch dargestellt und oben bereits erläutert, weist die Elektronikbaugruppe 100 ein Gehäuse 1, eine Kühleinrichtung 2, eine leistungselektronische Schaltung 3, eine signalelektronische Schaltung 4 und optional eine Filterschaltung 5 auf.

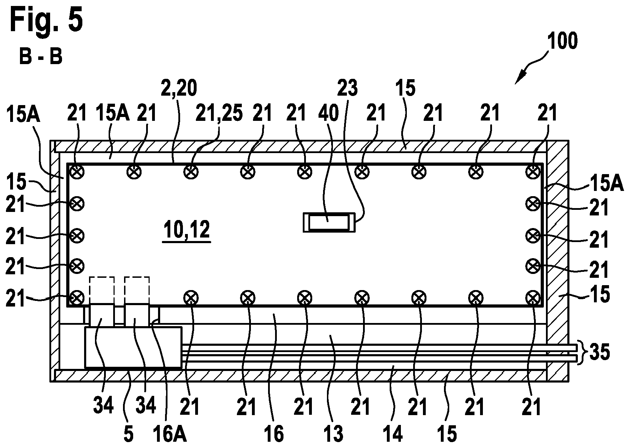

Wie insbesondere in Fig. 3 erkennbar, kann das Gehäuse 1 einen Boden 14 sowie mehrere miteinander verbundene, sich von dem Boden 14 aus quer zu diesem erstreckende Seitenwandungen 15 und einen Deckel 17 aufweisen. Wie in Fig. 5 gezeigt, kann der Boden 14 z.B. einen rechteckförmigen Umfang aufweisen und an jeder Umfangsseite kann je eine Seitenwandung 15 vorgesehen sein. Das Gehäuse 1 ist jedoch nicht auf dies Form beschränkt. Es ist z.B. auch denkbar, dass der Boden 14 einen kreisförmigen Umfang aufweist und eine durchgehende Seitenwandung 15 sich entlang des gesamten Umfangs des Bodens 14 erstreckt. Die Seitenwand bzw. die Seitenwandungen 15 und der Boden 14 definieren somit einen Innenraum 10 des Gehäuses 1. Optional kann an zumindest einer Seitenwand 15 ein quer zu dieser in den Innenraum 10 vorspringender Absatz 15A ausgebildet sein, wie in Fig. 3 schematisch gezeigt. Beispielsweise kann an drei Seitenwänden 15, die sich entlang aneinander angrenzende Seiten des rechteckigen Bodens 14 erstrecken, ein Absatz 15A ausgebildet sein, wie dies in Fig. 4 beispielhaft dargestellt ist.

Wie in Fig. 3 ferner gezeigt ist, kann das Gehäuse 1 optional eine Trennwand 16 aufweisen, welche mit einer oder mehreren Seitenwandungen 15 verbunden ist und mit dieser Seitenwand 15 bzw. diesen Seitenwandungen 15 jeweils einen geschlossenen Umfang ausbildet. Beispielsweise kann sich die Trennwand 16 zwischen zwei einander gegenüberliegenden Seitenwandungen 15 und parallel zu einer diese verbindenden weiteren Seitenwand 15 erstrecken, wie dies in Fig. 5 beispielhaft gezeigt ist. Wie in Fig. 3 schematisch dargestellt ist, kann insbesondere vorgesehen sein, dass die Trennwand 16 mit dem Boden 14 verbunden ist und sich von dem Boden 14 aus und quer zu diesem erstreckt bzw. von diesem vorspringt. Somit trennt die Trennwand 16 zwei Teilbereiche des Innenraums 10 voneinander, wie dies insbesondere in Fig. 3 erkennbar ist. Optional kann die Trennwand 16 eine Ausnehmung 16A aufweisen, wie in Fig. 3 weiterhin gezeigt ist.

Der Deckel 17 kann beispielsweise eine Abdeckplatte 17A aufweisen, welche eine durch die Seitenwand 15 oder die Seitenwandungen 15 umgrenzte Öffnung abdeckt. Beispielsweise kann die Abdeckplatte 17 an entgegengesetzt zu dem Boden 14 gelegenen Enden der Seitenwandungen 15 angeordnet sein. Die Abdeckplatte 17A kann insbesondere lösbar mit den Seitenwandungen 15 verbunden sein, z.B. mittels Schrauben 17C, wie dies in den Fig. 3 und 4 schematisch dargestellt ist. Optional kann der Deckel 17 ferner eine Trennleiste 17B aufweisen, welche von der Abdeckplatte 17A vorspringt. Wie in Fig. 3 beispielhaft gezeigt, ragt die Trennleiste 17B in den Innenraum 10 des Gehäuses 1 und kann gegebenenfalls fluchtend zu einer Seitenfläche der Trennwand 16 angeordnet sein, wenn die Abdeckplatte 17A die durch die Seitenwand 15 oder die Seitenwandungen 15 umgrenzte Öffnung abdeckt.

Der Boden 14, die Seitenwandungen 15, die Trennwand 16 können insbesondere einstückig ausgebildet sein, z.B. können sie gemeinsam in einem Gießverfahren hergestellt werden. Allgemein können der Boden 14, die Seitenwandungen 15, die Trennwand 16 sowie der Deckel 17 aus einem elektrisch leitfähigen Material hergestellt sein, insbesondere aus einem Metallmaterial, wie z.B. einer Aluminiumlegierung oder dergleichen. Allgemein ist zumindest teilweise aus einem elektrisch leitfähigen Material gebildet.

Die Kühleinrichtung 2 ist allgemein plattenförmig ausgebildet und weist daher eine flächige Erstreckung auf. Beispielsweise kann die Kühleinrichtung 2 eine Kühlplatte 20 aus einem elektrisch leitfähigen Material aufweisen. Allgemein weist die Kühlplatte 20 eine erste Oberfläche 20a und eine entgegengesetzt zu dieser orientierte zweite Oberfläche 20b auf, wobei zumindest die erste Oberfläche 20a ein elektrisch leitfähiges Material aufweist. Die erste Oberfläche 20a der Kühlpatte 20 bildet eine erste Oberfläche 2a der Kühleinrichtung 2. Die zweite Oberfläche 20b der Kühlpatte 20 bildet eine zweite Oberfläche 2a der Kühleinrichtung 2. Die Kühlplatte 20 kann z.B. einen rechteckförmigen Umfang aufweisen, wie dies in Fig. 5 beispielhaft dargestellt ist. Jedoch ist die Kühlplatte 20 nicht auf diese Form beschränkt, sondern kann auch andere Formen aufweisen, z.B. kreisförmig, trapezförmig usw. wobei im Querschnitt bzw. im Inneren der Kühlplatte 20 eine Leitungsstruktur 22 zum Durchleiten eines Kühlfluids ausgebildet ist, wie dies in Fig. 3 rein beispielhaft und lediglich schematisch dargestellt ist. Wie in Fig. 3 gezeigt, können z.B. Kanäle 22 im Inneren der Kühlplatte 20 verlaufen, durch welche ein Kühlfluid, wie z.B. Wasser geleitet wird. Wie in Fig. 3 rein schematisch gezeigt, kann die Leitungsstruktur 22 über eine Anschlussleitung 24 mit einem Kühlkreislauf (nicht gezeigt) verbunden werden, um an der Kühlplatte 20 aufgenommene Wärme abzuführen. Die Anschlussleitung 24 kann beispielsweise in einer Seitenwand 15 des Gehäuses 1, insbesondere in dem optionalen Absatz 15A verlaufen, wie in Fig. 3 rein bespielhaft dargestellt. Wie in den Fig. 3 und 5 ferner gezeigt ist, kann die Kühlplatte 20 eine Ausnehmung 23 aufweisen, die sich zwischen der ersten und der zweiten Oberfläche 20a, 20b der Kühlplatte 20 erstreckt.

Die Kühleinrichtung 2 ist im Innenraum 10 des Gehäuses 1 angeordnet. Wie insbesondere in Fig. 3 dargestellt, kann die Kühleinrichtung 2 sich insbesondere parallel zum Boden 14 erstrecken. Insbesondere kann die Kühleinrichtung 2, insbesondere die erste Oberfläche 20a der Kühlpatte 20 an einem abgewandt vom Boden 14 gelegenen Ende der Trennwand 16 und dem optionalen Absatz 15A der Seitenwandung 15 anliegen, wie in Fig. 3 beispielhaft gezeigt. Allgemein ist somit eine Oberfläche 2a der Kühleinrichtung 2 aus elektrisch leitfähigem Material in elektrisch leitendem Kontakt mit einem elektrisch leitfähigen Bereich des Gehäuses 1 angeordnet. In Fig. 3 ist beispielhaft gezeigt, dass eine erste Zone 11 im Innenraum 10 des Gehäuses 1 durch den Boden 14 des Gehäuses 1, durch zumindest eine Seitenwandung 15, durch die Trennwand 16 und durch die Kühleinrichtung 2 begrenzt ist. Ohne die Trennwand 16 kann die erste Zone 11 auch nur durch den Boden 14, die Seitenwandungen 16 und die Kühleinrichtung 2 begrenzt sein. Somit kann die erste Zone 11 allgemein durch den Boden 14 des Gehäuses 1, vom Boden 14 des Gehäuses 1 vorstehende Wandungen 15, 16 und durch die Kühleinrichtung 2 begrenzt sein.

Eine zweite Zone 12 im Innenraum 10 des Gehäuses 1 ist durch die Kühleinrichtung 2 von der ersten Zone 11 getrennt. Wie in Fig. 3 beispielhaft gezeigt, kann die zweite Zone 12 beispielsweise durch die Kühleinrichtung 2, durch zumindest eine Seitenwandung 15 des Gehäuses 1, durch die Abdeckplatte 17A des Deckels 17 und durch die Trennleiste 17B, welche in Richtung der Kühleinrichtung 2 bzw. der zweiten Oberfläche 20b der Kühlplatte 2 vorspringt, begrenzt sein. Ohne die Trennleiste 17B kann die zweite Zone 12 auch durch die Kühleinrichtung 2, die Abdeckplatte 17A und nur die Seitenwandungen 15 oder zumindest eine Seitenwandung 15 und die Trennwand 16 begrenzt sein. Allgemein kann die zweite Zone 12 daher durch die Kühleinrichtung 2, zumindest teilweise durch die vom Boden 14 des Gehäuses 1 vorstehende Wandungen 15, 16 und durch den Deckel 17 des Gehäuses 1 begrenzt ist.

Wie aus der in den Fig. 3 bis 5 gezeigten Anordnung der Kühleinrichtung 2 im Innenraum 10 und den voranstehenden Ausführungen ersichtlich ist, ist die Kühleinrichtung 2 allgemein in dem Innenraum 10 des Gehäuses 1 angeordnet und trennt in dem Innenraum 10 eine erste Zone 11 und eine zweite Zone 12 voneinander.

Wie in den Fig. 3 und 5 weiterhin beispielhaft gezeigt ist, kann eine optionale dritte Zone 13 des Innenraums 10 des Gehäuses 1 durch die Trennwand 16 von der ersten Zone 11 getrennt sein. Die dritte Zone 13 kann optional durch die Trennleiste 17B des Deckels 17 von der zweiten Zone 12 getrennt sein, wie in Fig. 3 weiterhin beispielhaft gezeigt ist. Somit kann die dritte Zone 13 z.B. durch den Boden 14, zumindest eine Seitenwand 15, die Trennwand 16, die Trennleiste 17B und die Abdeckplatte 17A umgrenzt sein.

Zur Fixierung und/oder zur Herstellung der elektrisch leitfähigen Verbindung zwischen Kühleinrichtung 2 und Gehäuse 1 kann die Kühleinrichtung 2 entlang ihres Umfangs an einer Vielzahl von Verbindungsstellen 21 mit dem Gehäuse 1 verbunden sein, insbesondere in elektrisch leitfähiger Weise. Wie insbesondere in den Fig. 3 und 4 schematisch dargestellt ist, können die Kühleinrichtung 2 bzw. die Kühlplatte 20 und das Gehäuse 1 an den Verbindungsstellen 21 durch Schrauben 25 miteinander verbunden sein. Alternativ wäre es auch denkbar, die Kühlplatte 20 und das Gehäuse 1 an den Verbindungsstellen 21 zu verschweißen oder zu verrasten, um jeweils eine elektrisch leitfähige und vorzugsweise auch bewegungsfeste Verbindung zu erzielen. Wie in den Fig. 4 und 5 beispielhaft gezeigt ist, können die Verbindungsstellen 21 insbesondere äquidistant zueinander angeordnet sein.

Wie in Fig. 3 schematisch dargestellt, ist die leistungselektronische Schaltung 3 ist in der ersten Zone 11 des Innenraums 10 des Gehäuses 1 angeordnet. Die leistungselektronische Schaltung 3 kann beispielsweise eine Umrichterschaltung 31 aufweisen, die dazu eingerichtet ist, eine elektrische Gleichspannung in eine elektrische Wechselspannung umzurichten und eine elektrische Wechselspannung in eine elektrische Gleichspannung umzurichten. Wie in Fig. 3 schematisch dargestellt, kann die Umrichterschaltung 31 einen beispielsweise dreipoligen Anschluss 33 zur elektrischen Verbindung mit der elektrischen Maschine 210 aufweisen. Optional kann die leistungselektronische Schaltung 3 zusätzlich einen Zwischenkreiskondensator 32 aufweisen, welcher elektrisch in Reihe mit der Umrichterschaltung 31 geschalten ist. Gegebenenfalls kann in der optionalen dritten Zone eine Filterschaltung 5 angeordnet sein, welche elektrisch in Reihe mit der leistungselektronischen Schaltung 3 geschalten ist, insbesondere mit dem Zwischenkreiskondensator 32. Die leistungselektronische Schaltung 3 und die optionale Filterschaltung 5 können durch Leitungsschienen 34 verbunden sein, welche sich durch die Ausnehmung 16A der Trennwand 16 hindurch erstrecken, wie dies in den Fig. 3, 4 und 5 schematisch gezeigt ist. Die Filterschaltung 5 und der Zwischenkondensator 32 können dazu eingerichtet sein, Spannungsrippel bzw. Rippelströme in unterschiedlichen Frequenzbereichen zu filtern. Wie in Fig. 5 rein schematisch angedeutet ist, kann die Filterschaltung 5 elektrisch mit einem beispielsweise zweipoligen Anschluss 36 verbunden, welcher zum Anschluss an die Energiespeichervorrichtung 310 vorgesehen ist.

Wie in Fig. 3 schematisch dargestellt, ist die signalelektronische Schaltung 4 ist in der zweiten Zone 12 des Innenraums 10 angeordnet. Beispielsweise kann die signalelektronische Schaltung 4 in Kontakt mit der zweiten Oberfläche 2a der Kühleinrichtung 2 stehen, um die Wärmeabgabe an die Kühleinrichtung 2 zu verbessern. Die signalelektronische Schaltung 4 ist in den Fig. 2 und 3 lediglich symbolisch als Block dargestellt und kann z.B. eine Logikschaltung, eine Prozessoreinheit, wie z.B. eine CPU, einen FPGA, einen ASIC oder dergleichen, einen Speicherbaustein etc. aufweisen. Die signalelektronische Schaltung 4 ist durch eine Verkabelung 40 zur Signalübertragung elektrisch mit der leistungselektronischen Schaltung 3, insbesondere mit der Umrichterschaltung 31 verbunden, um deren Betrieb zu steuern und/oder zu regeln. Die Verkabelung 40 kann hierbei insbesondere durch die Ausnehmung 23 der Kühlplatte 20 geführt sein, wie dies in Fig. 3 schematisch dargestellt ist.

Wie aus den Fig. 3 bis 5 erkennbar ist, wird durch die Trennung der ersten und der zweiten Zone 11, 12 im Innenraum 10 des Gehäuses 1 durch die elektrisch mit dem Gehäuse 1 verbundene Kühleinrichtung 2 eine platzsparende und konstruktiv einfach aufgebaute elektromagnetische Abschirmung der leistungselektronischen Schaltung 3 und der signalelektronischen Schaltung 4 realisiert. Insbesondere wird er Integrationsgrad der Elektronikvorrichtung 100 verbessert, da nicht zwangsläufig zusätzliche Abschirmbleche oder dergleichen vorgesehen sein müssen.

Obwohl die vorliegende Erfindung vorstehend anhand von Ausführungsbeispielen exemplarisch erläutert wurde, ist sie darauf nicht beschränkt, sondern auf vielfältige Weise modifizierbar. Insbesondere sind auch Kombinationen der voranstehenden Ausführungsbeispiele denkbar. Ferner ist die vorliegende Erfindung nicht auf die Anwendung in Antriebsvorrichtungen von Fahrzeugen beschränkt, sondern kann allgemein im Zusammenhang mit Frequenzumrichtern mit geregeltem Netzgleichrichter eingesetzt werden. Beispielsweise ist die Erfindung auch bei wechselrichtergespeisten Industrieantriebe, Ladegeräten, insbesondere im Elektro-/ Hybridfahrzeugbereich, oder in ähnlichen Gebieten einsetzbar.

## Patentansprüche

1. Elektronikbaugruppe (100) für eine elektrische Antriebsvorrichtung (200), mit:
einem Gehäuse (1), welches einen Innenraum (10) definiert und zumindest teilweise aus einem elektrisch leitfähigen Material gebildet ist; einer plattenförmigen Kühleinrichtung (2), welche in dem Innenraum (10) des Gehäuses (1) angeordnet ist und in dem Innenraum (10) eine erste Zone (11) und eine zweite Zone (12) voneinander trennt, wobei die plattenförmige Kühleinrichtung (2) eine Oberfläche (2a) aus elektrisch leitfähigem Material aufweist, welche in elektrischem Kontakt mit einem elektrisch leitfähigen Bereich des Gehäuses (1) angeordnet ist;
einer in der ersten Zone (11) des Innenraums (10) angeordneten leistungselektronischen Schaltung (3) zur elektrischen Verbindung mit einer elektrischen Maschine (210); und
einer in der zweiten Zone (12) des Innenraums (10) angeordneten signalelektronischen Schaltung (4), welche elektrisch mit der leistungselektronischen Schaltung (3) verbunden und dazu eingerichtet ist, diese zu steuern.

2. Elektronikbaugruppe (100) nach Anspruch 1, wobei die Kühleinrichtung (2) entlang ihres Umfangs an einer Vielzahl von Verbindungsstellen (21), die vorzugsweise äquidistant zueinander angeordnet sind, elektrisch leitfähig mit dem Gehäuse (1) verbunden ist.

3. Elektronikbaugruppe (100) nach Anspruch 1 oder 2, wobei die erste Zone (11) durch einen Boden (14) des Gehäuses (1), vom Boden (14) des Gehäuses (1) vorstehende Wandungen (15, 16) und durch die Kühleinrichtung (2) begrenzt ist.

4. Elektronikbaugruppe (100) nach Anspruch 3, wobei die erste Zone (11) durch den Boden (14) des Gehäuses (1), durch zumindest in einem Randbereich des Bodens (14) angeordnete Seitenwandung (15), durch eine mit der Seitenwandung (15) verbundene Trennwand (16) und durch die Kühleinrichtung (2) begrenzt ist.

5. Elektronikbaugruppe (100) nach Anspruch 4, wobei die Trennwand (16) in dem Innenraum (10) des Gehäuses (1) eine dritte Zone (13) von der ersten Zone (11) trennt, und wobei in der dritten Zone (13) eine Filterschaltung (5) angeordnet ist, welche elektrisch in Reihe mit der leistungselektronischen Schaltung (3) geschalten ist.

6. Elektronikbaugruppe (100) nach einem der Ansprüche 3 bis 5, wobei die zweite Zone (12) durch die Kühleinrichtung (2), zumindest teilweise durch die Wandungen (15, 16) und durch einen Deckel (17) des Gehäuses (1) begrenzt ist.

7. Elektronikbaugruppe (100) nach Anspruch 6, wobei die zweite Zone (12) durch die Kühleinrichtung (2), durch zumindest eine mit dem Boden (14) verbundene Seitenwandung (15) des Gehäuses (1), durch eine sich quer zu der Seitenwandung (15) erstreckende Abdeckplatte (17A) des Deckels (17) und durch eine von dem Deckel (17) in Richtung der Kühleinrichtung (2) vorspringende Trennleiste (17B) begrenzt ist.

8. Elektronikbaugruppe (100) nach einem der voranstehenden Ansprüche, wobei die leistungselektronische Schaltung (3) aufweist:
eine Umrichterschaltung (31), die dazu eingerichtet ist, eine elektrische Gleichspannung in eine elektrische Wechselspannung umzurichten und
eine elektrische Wechselspannung in eine elektrische Gleichspannung umzurichten, und
einen Zwischenkreiskondensator (32), welcher elektrisch in Reihe mit der Umrichterschaltung (31) geschalten ist.

9. Elektronikbaugruppe (100) nach einem der voranstehenden Ansprüche, wobei die Kühleinrichtung (2) eine Kühlplatte (20) aus einem elektrisch leitfähigen Material aufweist, wobei im Querschnitt der Kühlplatte (20) eine Leitungsstruktur (22) zum Durchleiten eines Kühlfluids ausgebildet ist.

10. Elektrische Antriebsvorrichtung (200) für ein Fahrzeug (300), mit
einer Elektronikbaugruppe (100) nach einem der voranstehenden Ansprüche; und
einer elektrischen Maschine (210), welche elektrisch mit der leistungselektronischen Schaltung (3) der Elektronikbaugruppe (100) verbunden ist.
